(19) **Europäisches Patentamt**

**European Patent Office**

**Office européen des brevets**

(11) **EP 1 143 222 A1**

(12) # EUROPEAN PATENT APPLICATION

(43) Date of publication:
**10.10.2001 Bulletin 2001/41**

(51) Int Cl.$^7$: **G01B 11/06**, H01L 21/66

(21) Application number: **01107757.5**

(22) Date of filing: **03.04.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **06.04.2000 US 544353**

(71) Applicant: **APPLIED MATERIALS, INC.**
**Santa Clara, California 95054-3299 (US)**

(72) Inventors:
• **Subrahmanyan, Suchitra**
**Sunnyvale, California 94086 (US)**
• **Samoilov, Arkadii V.**
**Sunnyvale, California 94087 (US)**
• **Mosely, Roderick C.**
**Pleasanton, California 94588 (US)**

(74) Representative: **Käck, Jürgen**
**Kahler, Käck, Fiener et Col.**
**Vorderer Anger 268**
**86899 Landsberg (DE)**

(54) **Method and apparatus for detecting the thickness of copper oxide**

(57)    A method and apparatus are provided for measuring the thickness of a copper oxide layer ($S_2$) formed on an underlying copper layer ($S_1$). The method either measures a bulk characteristic of the copper layer, through the copper oxide layer (as in the case of sheet resistance) or determines the thickness of the copper oxide by measuring the attenuation caused by the copper oxide, which is a monotonic function of the thickness of the copper oxide layer (as in the case of reflectivity). A processor (15) stores correlated data (e. g., reflectivity measurements obtained for various copper oxide thicknesses) or a relationship (e.g., a formula) which correlates a given measurement to a given copper oxide thickness. The method may be used in situ or ex situ and during either vacuum or non-vacuum processes.

FIG. 1A

**Description**

FIELD OF THE INVENTION

The present invention relates to a method and apparatus for detecting the thickness of copper oxide. More specifically, the present invention relates to the use of reflectivity or sheet resistance, to determine the thickness of a copper oxide layer formed on a substrate.

BACKGROUND

The drive for faster semiconductor devices has caused the semiconductor industry to seek metals which provide lower resistance (and therefore faster operating speeds) than that of conventional aluminum layers. Copper is a strong candidate for replacing aluminum, as copper has low resistivity (1.7 micro-ohm-cm as compared to the 2.7 micro-ohm-cm of aluminum) and high resistance to electromigration. Unfortunately, a major drawback of copper is its propensity to readily oxidize when exposed to an oxygen rich environment (e.g., water vapor, air, etc.). The copper oxide which forms has an extremely high resistance (e.g., about 10 ohm-cm) and should be completely removed from the underlying copper in order to create a metal interconnect that fully benefits from the low resistivity of pure copper.
When removing copper oxide it is important to ensure that all of the copper oxide is removed to achieve the lowest possible resistivity, without unduly wasting the additional time and material associated with over-removal (i.e., removing a portion of the underlying non oxidized copper layer).
Copper oxide thickness may be measured via ellipsometry, a method which is undesirable due to the cost and complexity of the measurement tool. Thus, there is a need for a method and apparatus which accurately measures the thickness of copper oxide. Preferably such an apparatus would operate during the copper oxide removal process, thus providing copper oxide thickness data in situ as the copper oxide layer diminishes. Moreover, a copper oxide measurement tool is needed which can quickly provide reliable measurements with minimal equipment cost.

SUMMARY OF THE INVENTION

The invention is defined in claims 1, 4, 10, 13, 14, 17, 20, 23, 26, and 30, respectively.
The present inventors have discovered two new measurement regimes that provide highly accurate copper oxide thickness measurements using simple, cost effective measurement equipment. Specifically, the present inventors have discovered a relationship between copper oxide thickness and reflectivity, and a relationship between copper oxide thickness and sheet resistance. Unlike ellipsometry techniques, the inventive reflectivity based copper oxide thickness measurement does not rely on interference between lights of differing wavelengths which reflect from the surface of the copper and the surface of the copper oxide. Rather, the present inventors illuminate a substrate with a light (e.g., of one or more wavelengths), and measure the light which reflects therefrom. The measurement regime employed by the present inventors exhibits a reflectivity (and/or a sheet resistance) measurement that varies with the copper oxide's thickness.
To obtain a reflectivity measurement that varies with copper oxide thickness, the present method reflects light from the underlying copper layer. To the extent that a copper oxide is formed thereon, the copper oxide absorbs the light. The thicker the copper oxide layer, the greater the absorption and the lower the measured reflectivity. Similarly, the sheet resistance measurement is that of the underlying copper, as measured through the copper oxide layer. The thicker the copper oxide layer, the higher the measured sheet resistance. Each measurement technique thus provides an extremely simple and highly accurate copper oxide thickness measurement.
Further, the inventors determined that the relationship between the reflectivity/sheet resistance measurements and the copper oxide thickness exist regardless of variations in wafer processing (e.g., annealing temperature, annealing time, annealing environment, etc.). Thus, inventive copper oxide measurement regimes which rely on these relationships are universally applicable for measuring the thickness of any copper oxide, regardless of the previously performed processing steps. Moreover, conventional tools for measuring reflectivity and sheet resistance may be easily modified to perform the invention by providing the tools with relationship information such as a database, or a mathematical function (as explained further below) which correlates reflectivity and/or sheet resistance to copper oxide thickness.
Specifically, to obtain this correlated information, the reflectivity and/or sheet resistance of copper oxides of various known thicknesses (e.g., copper oxides whose thicknesses have been measured by conventional methods such as via use of an ellipsometry measurement tool) were measured, and the measured reflectivity and/or sheet resistance values were recorded with the corresponding thickness value, to provide a database of correlated values. It will be understood that as used herein copper oxide reflectivity refers to the reflectivity measurement obtained when light strikes a structure comprising a copper layer having a copper oxide formed therein and reflects therefrom, and that copper oxide sheet resistance refers to the sheet resistance measurement obtained when the sheet resistance of an underlying copper layer is measured through a copper oxide layer.

In a first aspect of the invention, a database of corresponding values is coupled to a reflectivity or sheet resistance measurement tool and a controller (either a controller which controls the operation of the measurement tool or a separate controller) is programmed to receive a value measured by the tool, look the measured value up in the database, and send the corresponding copper oxide thickness value to an output device (e.g., a display screen, a printout, a database that records the copper oxide thickness value and a wafer identifier, etc.).

In a second aspect, a mathematical function (e.g., a factor, a multiplicand, a divisor, an equation, etc.) which correlates reflectivity or sheet resistance to copper oxide thickness is provided for a reflectivity or sheet resistance measurement tool, and a controller (either a controller which controls the operation of the measurement tool or a separate controller) is programmed to receive a measured value, to perform the mathematical function which correlates the measured value to copper oxide thickness, and to send the resultant copper oxide thickness value to an output device.

In a third aspect, an inventive tool configured to measure reflectivity of a copper oxide, and based thereon to output the copper oxide's thickness, is coupled to a vacuum processing chamber configured to perform a copper oxide removal process (e.g., reduction, sputter etching, etc.). The inventive measurement tool is coupled so as to perform copper oxide reflectivity measurements on a substrate located within the tool. This aspect allows the inventive tool to perform valuable process monitoring/process characterizing functions, as well as valuable endpoint detection functions, and allows copper oxide thickness to be measured from outside a vacuum processing chamber, without breaking the processing tool's vacuum environment.

Further aspects of the invention measure other bulk characteristics of copper through a copper oxide layer, and may perform in situ copper oxide measurements during non-vacuum processes such as during chemical mechanical polishing.

Because of the simplicity of the measurements employed, each aspect of the invention reduces measurement signal processing time, and equipment cost associated with conventional copper oxide thickness measurements. Accordingly, a semiconductor processing system which employs the inventive tool will experience greater throughput, and reduced cost per wafer unit processed. Moreover, the invention allows copper oxide thickness measurements to be made during value added processing steps (e.g., during copper oxide removal) and can be used to provide process characterizations which enable selection of processing times which avoid or minimize the overetching required when conventional copper oxide measurements are employed.

Other objects, features and advantages of the present invention will become more fully apparent from the following detailed description of the preferred embodiments, the appended claims and the accompanying drawings.

BRIEF DESCRIPTION OF THE DRAWINGS

FIG. 1A is a schematic side elevational view of an inventive reflectivity based copper oxide measurement tool;

FIG. 1B is schematic side elevational view of an inventive sheet resistance based copper oxide measurement tool;

FIG. 2A is a schematic side elevational view of a semiconductor wafer processing system having the inventive copper oxide measurement tool of FIG. 1A coupled thereto;

FIG. 2B is a flow chart which describes the operation of the inventive measurement tool;

FIG. 3 is a side elevational view of a preferred semiconductor wafer processing system configured for a copper oxide reduction processes;

FIG. 4 is a cross-sectional view of a preferred semiconductor wafer processing system configured for sputter etching copper oxide from an underlying copper layer; and

FIG. 5A is a graph of copper oxide thickness versus reflectivity measured at 436 and 480 nanometers; and

FIG. 5B is a graph of copper oxide thickness versus sheet resistance.

DETAILED DESCRIPTION OF THE PREFERRED EMBODIMENTS

The inventive copper oxide thickness measurement apparatus, whether a reflectivity or sheet resistance based apparatus, may be employed as a stand-alone unit (e.g., for measuring copper oxide thickness before or after a copper oxide removal process).

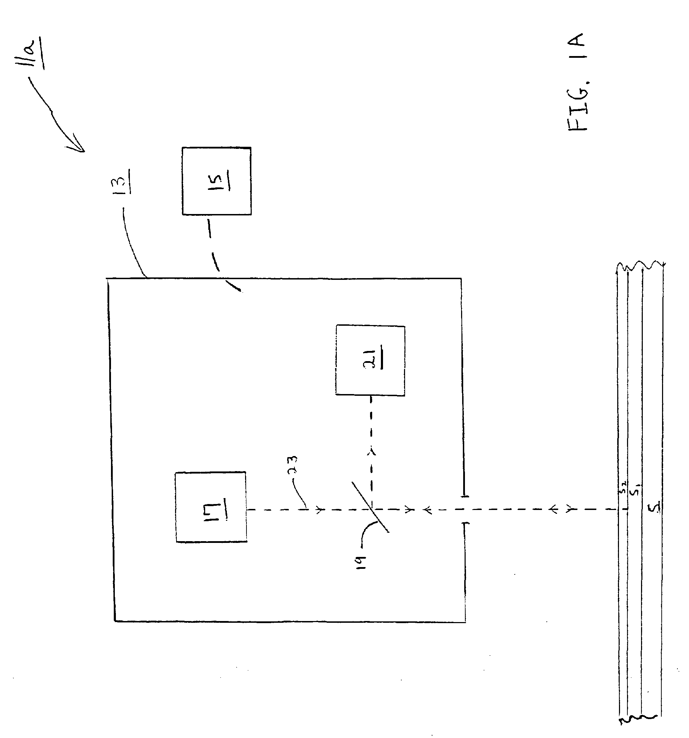

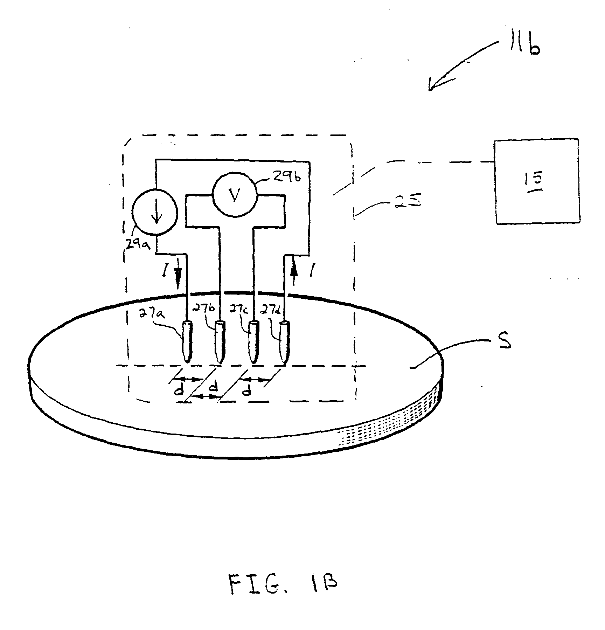

FIG. 1A is a schematic side elevational view of a reflectivity based copper oxide measurement tool 11a. The inventive tool 31a comprises a reflectivity measurement component 13, and a processor 15. The processor 15 may be integrated within the reflectivity measurement component 13 or maybe external thereto as shown in FIG. 1A. The processor 15 may be a controller specific to the reflectivity measurement component 13, may be a controller which controls an overall semiconductor fabrication system such as the Centura™ manufactured by Applied Materials, Inc., or may be part of a larger controller such as a manufacturing execution system. The processor 15 is adapted to determine the thickness of copper oxide based on the reflectivity measured by the reflectivity measurement component 13. Specifically the processor 15 may comprise a database such as a lookup table containing various reflectivities, and the various copper oxide thicknesses corresponding thereto.

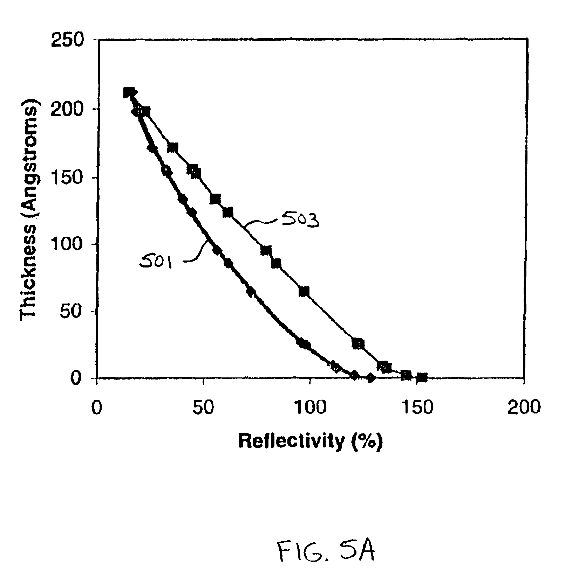

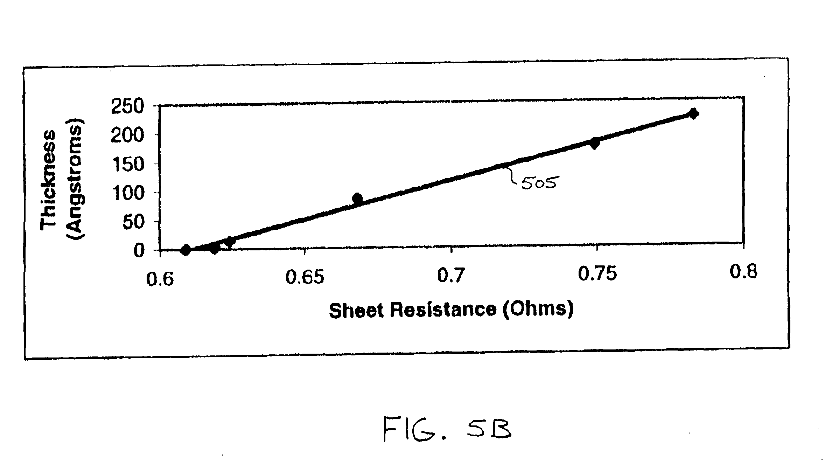

Table 1-1 below is an exemplary lookup table which was created by measuring the thickness of various copper oxides with an ellipsometry tool such as KLA Tencor's UV-1250 SE. Tencor's ellipsometry measurement tool directs polarized light having a wavelength of 633 nm at a copper oxide and analyzes the reflected beam. The copper oxide measurement recipe contained within the ellipsometry tool measures the amplitude and phase of the reflected light and fits the measured amplitude and phase using the refractive index and the extinction coefficient of copper oxide and the thickness of the copper oxide layer as fitting parameters. Each data point represents the reflectivity (normalized to a silicon wafer) of a different semiconductor wafer having a copper layer with a copper oxide formed thereon. To generate different copper oxide layer thicknesses, wafers with a copper layer were annealed at 120°C, 130°C and 140°C in air for varying time periods. Note that for a given wavelength, all the reflectivity data lies on a single curve (regardless of the processing conditions employed to grow each copper oxide layer) as shown by FIG. 5A which is a plot of the data table 1-1.

TABLE 1-1

| THICKNESS (ANGSTROMS) | % REFLECTIVITY AT 436 NANOMETERS | % REFLECTIVITY AT 480 NANOMETERS |
|---|---|---|
| 0 | 128.5 | 152.5 |
| 1.7 | 121 | 145 |
| 7 | 113 | 136 |
| 9 | 111 | 134 |
| 25 | 98 | 123 |
| 26.5 | 96 | 122 |
| 64 | 72 | 97 |
| 85 | 61.5 | 84 |
| 95 | 56 | 79 |
| 124 | 44 | 61 |
| 134 | 39.5 | 55 |
| 153 | 32.5 | 45.5 |
| 156 | 31.5 | 44 |
| 172 | 25 | 34.5 |
| 198 | 17.5 | 21.5 |
| 212 | 15.4 | 14 |

As the data contained in table 1-1 shows, the thicker the copper oxide layer, the greater the absorption of light by the copper oxide layer, and the smaller the reflectivity thereof. As stated, the data contained in table 1-1 was obtained by using a silicon wafer as a reference (that is, the reflectivity of the bare silicon wafer was taken as 100 percent). All the reflectivity data is therefore shown in percent with respect to the reflectivity of silicon.

Alternatively, rather than employing a database or lookup table such as that provided above, the processor 15 may store a mathematical function which relates reflectivity to copper oxide thickness. For example, the data within table 1-1 may be fit to a curve (curve 501 for 436 nm data and curve 503 for 480 nm data as shown in FIG. 5A), with the 436 nm data curve having the mathematical function:

$$T = 1 \times 10^{-6}(R_F)^4 - 0.0004(R_F)^3 + 0.0572(R_F)^2 - 5.3379(R_F) + 278.94$$

wherein T is the thickness of the copper oxide layer (in angstroms) and $R_F$ is the measured reflectivity (in %) . Accordingly, for any measured reflectivity value, copper oxide thickness can be easily computed.

The reflectivity measurement component 13 may comprise any conventionally available reflectivity measurement tool. The present inventors have used Nanometrics 210 film thickness measurement system (which is sold under the trade name Nanospec/AFT) at wavelengths of 436 nm and 480 nm, with a magnification of 40. However, in general, reflectivity measurement component 13 contains a monochromatic light source 17 (e.g., a laser or a lamp with a monochromator), a polarizing beam splitter 19, and a collector 21 (e.g., a photo diode).

In operation the light source 17 outputs a beam of light 23. The beam of light 23 passes through the polarizing beam splitter 19 where part of the light beam 23 (not shown) may be reflected away from both the substrate S and the collector 21. The remainder of the light beam 23 passes through the polarizing beam splitter 19, travels to the substrate S, where a portion (not shown) of the light beam 23 is absorbed, and a portion of light beam 23 is reflected back toward the polarizing beam splitter 19. If the substrate has a copper layer $S_1$, some of the reflected light is absorbed by a copper oxide layer $S_2$ (if any) formed on the copper layer $S_1$. The portion of the light beam 23 which is not absorbed is reflected from the substrate S to the polarizing beam splitter 19, and is then reflected from the polarizing beam splitter 19 to the collector 21, as shown. The processor 15 obtains the measured value of light collected by the collector 21 as compared to the measured value of light collected by the collector 21 for a bare silicon wafer (i.e., the measured reflectivity value), and determines the thickness of the copper oxide formed on the substrate S, either by looking up the reflectivity value in a lookup table stored within the processor 15, or by applying a mathematical function to the reflectivity value (as described above). Thereafter the processor 15 outputs (to an output device) the copper oxide thickness which corresponds to the measured reflectivity value. The output device may comprise any human readable form, such as a printout, a display screen, etc., or a machine controller which takes the valve and determines therefrom the duration or other quantities of the oxide removal step needed to optimally remove the oxide with minimal over etching.

FIG. 1B is schematic side elevational view of a sheet resistance based copper oxide measurement tool 11b. The inventive tool 11b comprises a sheet resistance measurement component 25, and a processor 15. The processor 15 may be integrated with the sheet resistance measurement component 25 or maybe external thereto as shown in FIG. 1B. The processor 15 may be a controller specific to the sheet resistance measurement component 25, may be a controller which controls an overall semiconductor fabrication system such as the Centura™ manufactured by Applied Materials, Inc., or may be part of a larger controller such as a manufacturing execution system. The processor 15 is adapted to determine the thickness of a copper oxide based on a sheet resistance measured by the sheet resistance measurement component 25. Specifically, processor 15 may comprise a database such as a lookup table containing various resistivities and the various copper oxide thicknesses corresponding thereto.

Table 1-2 below is an exemplary lookup table which was created by measuring the thickness of various copper oxides with KLA Tencor's UV 1250 SE ellipsometry measurement tool, as described above. As the data contained in table 1-2 shows, the thicker the copper oxide layer, the greater the sheet resistance. This is due to the fact that the initial thickness of deposited copper was constant for all the substrates measured so that as the thickness cf the copper oxide layer increases, the thickness of the underlying copper layer decreases.

TABLE 1-2

| THICKNESS (ANGSTROMS) | RESISTANCE (OHMS) |
|---|---|
| 0 | 0.609 |
| 2.33 | 0.619 |
| 13.14 | 0.624 |
| 85.4 | 0.668 |
| 175.65 | 0.749 |
| 223.7 | 0.783 |

Alternatively, rather than employing a database or lockup table such as that provided above, the processor 15 may store a mathematical function which relates sheet resistance to copper oxide thickness. For example, the data within table 1-2 may be fit to a curve (FIG. 5B) having the mathematical function:

$$T = 1304.6 \, (R_s) - 797.7$$

wherein T is the thickness of the copper oxide layer and $R_s$ is the measured sheet resistance. Accordingly, for any measured sheet resistance value, copper oxide thickness can be easily computed.

The sheet resistance measurement component 25 may comprise any conventionally available sheet resistance measurement tool. The present inventors have used OmniMap RS 75, with probe A. In general, however the sheet resistance measurement component 25 contains four co-linear, equally spaced (e.g., lmm apart) probes 27a-d coupled to a current source 29a and to a voltage meter 29b. In operation the probes 27a-d are brought into contact with a surface of the substrate S, and a known current (I) generated by the current source 29a is passed through the outer two probes 27a, 27d, while the potential (V) developed across the inner two probes 27b, 27c is measured by the voltage meter 29b is measured. The resistance method can be applied to copper oxide thickness measurements for processes in which the overall amount of copper (e.g., in the copper and copper oxide layers) is kept constant. In other words, the copper oxide is reduced, or converted, to copper by a chemical reaction without losing any copper from the surface, as described in more detail below.

In these processes, as the copper oxide thickness on the substrate S decreases, the resistance between the inner two probes 27b, 27c also decreases. This occurs because, as the thickness of the copper layer becomes larger, more and more copper is available for conducting electricity. The potential (V) developed between the two inner probes 27b, 27c therefore decreases with decreasing copper oxide thickness. The processor 15 receives the potential drop measured across the inner two probes and computes a sheet resistance value via the following equation:

$$R = (V/I)F$$

wherein:

R =    Sheet Resistance
V =    Voltage between the inner probes 27b, 27c
I =    Current driven through the outer probes 27a, 27d
F =    A dimensionless correction factor dependent on probe geometry as is known in the art

Note that a smaller potential (V) between the inner probes 27b, 27c results in a smaller resistance value.

Thereafter the processor 15 determines the thickness of the copper oxide formed on the substrate S, either by looking up the sheet resistance value in a lookup table stored within the processor 15, or by applying a mathematical function to the sheet resistance value. The processor 15 then outputs (to an output device) the copper oxide thickness which corresponds to the measured sheet resistance value. The output device may comprise any human readable form, such as a printout, a display screen, etc.

Both the reflectivity and the sheet resistance based copper oxide measurement tools 11a and 11b of FIGS. 1A and 1B may be advantageously employed after a copper oxide removal process, to determine whether all of the copper oxide has been successfully removed (e.g., if no copper oxide is present the measured reflectivity and sheet resistance will be that of pure copper -- about 128.5% at 436 nanometers and about 0.6 ohms for the data in Table 1-2, respectively), and/or before a copper oxide removal process. When employed before a copper oxide removal process, the inventive measurement tools determine the thickness of the copper oxide to be removed and, provided the copper oxide removal rate of the removal process is known, enable accurate calculation of the end point for the copper oxide removal process (e.g., with a removal rate of 20 A/sec, and a copper oxide thickness of 200 A, the end point of the copper oxide removal process would occur at ten seconds).

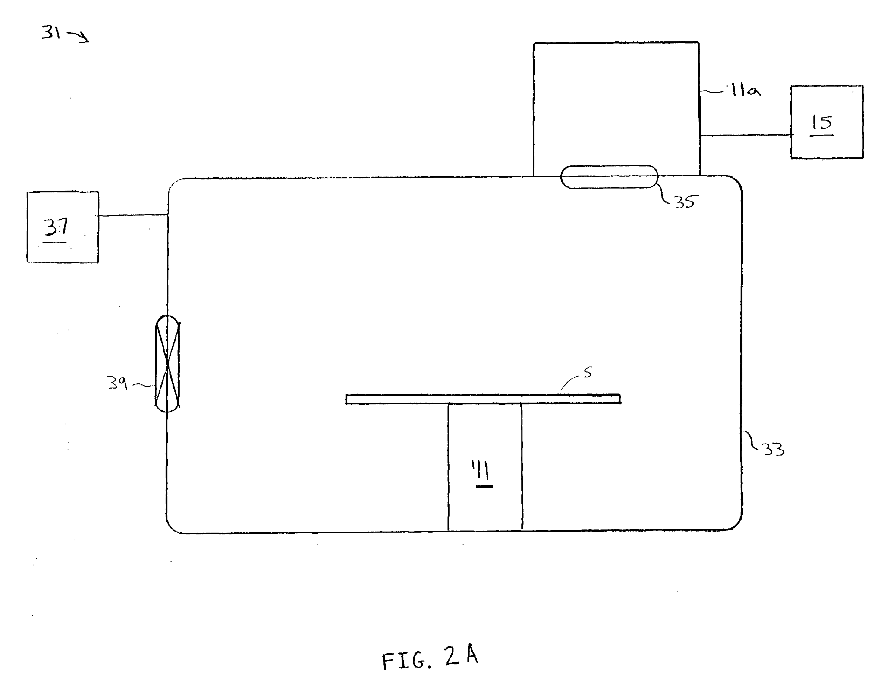

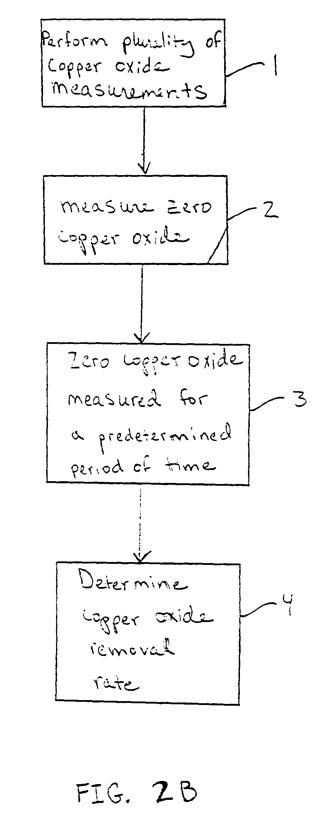

The reflectivity based copper oxide measurement tool 11a also can be employed to measure copper oxide thickness during a copper oxide removal process (i.e., in situ). Accordingly, as described further with reference to FIGS. 2A and 2B, the inventive copper oxide measurement tool 11a can be used to determine a copper oxide removal rate, and/or to characterize (e.g., identify process conditions which effect the copper oxide removal rate, etc.) a copper oxide removal process, as well as for in situ end point detection.

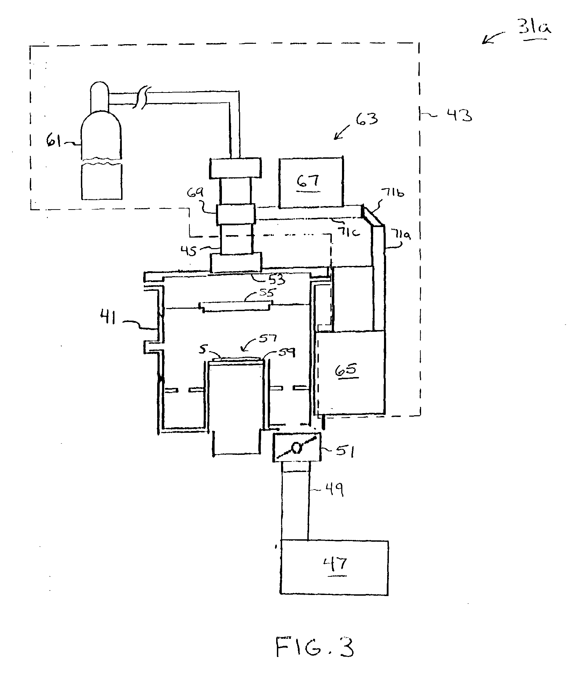

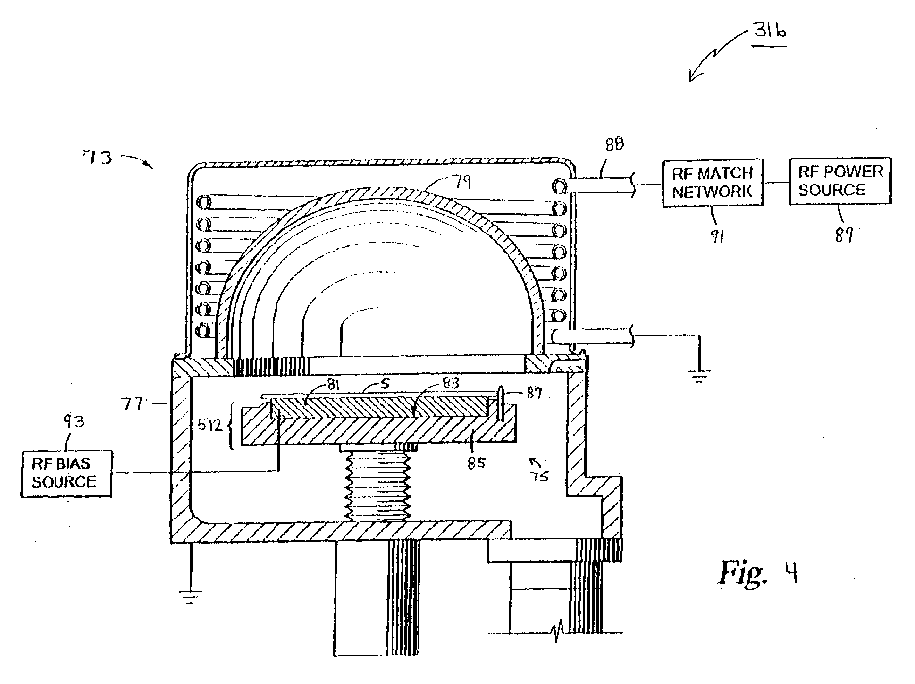

FIG. 2A is a schematic side elevational view of a semiconductor wafer processing system 31, having the inventive copper oxide measurement tool 11a coupled thereto. As used herein "coupled" means coupled directly or indirectly so as operate. The semiconductor wafer processing system 31 comprises a vacuum processing chamber 33 adapted to perform a copper oxide removal process (e.g., a reduction or sputter etching process as described in detail with reference to FIGS. 3 and 4, respectively) within a vacuum environment, and having a window 35 (e.g., a quartz window) through which the inventive copper oxide measurement tool 11a may perform its reflectivity measurements. The semiconductor wafer processing system 31 further comprises a controller 37 for controlling the copper oxide removal process. Although FIG. 2A shows the controller 37 of the vacuum processing chamber 33 separately from the processor 15 of the inventive copper oxide measurement tool 11a, it will be understood that the controller 37 and the processor 15 may be part of the same unit, and either or both may comprise part of a controller which controls an overall semiconductor fabrication system such as the Centura™ manufactured by Applied Materials, Inc. However, in this example it will be assumed that the controller 37 controls both the operation of the semiconductor wafer processing system 31, and the operation of the inventive copper oxide measurement tool 11a. Thus processor 15 merely stores data, and looks up the reflectivity values and corresponding copper oxide thicknesses, or applies the mathematical function to the reflectivity measurements.

The inventive copper oxide measurement tool 11a is positioned so that the light beam 23 (FIG. 1A) enters the vacuum processing chamber 33 via the window 35, strikes the substrate S positioned in the processing chamber 33, and travels back through the window 35 to the polarizing beam splitter 19 and is thereafter reflected to the collector 21 where, in conjunction with the processor 15, the copper oxide thickness (if any) is determined as previously described with reference to FIG. 1A.

The vacuum processing chamber 33 may be configured as described below with reference to FIGS. 3 or 4, and may perform the copper oxide reduction or copper oxide etching processes, respectively, described with reference to FIGS. 3 and 4. However, with reference to FIG. 2A, the operation of the semiconductor wafer processing system 31 and the copper oxide measurement tool 11a will be described generally, regardless of the specific copper oxide removal process performed thereby.

Specifically, in operation, a slit valve 39 located on the vacuum processing chamber 33, opens and a wafer handler (not shown) places a first substrate (having a copper oxide formed thereon) on a substrate support 41 located within the vacuum processing chamber 33. Thereafter the wafer handler retracts and the slit valve 39 closes, sealing the vacuum processing chamber 33. The vacuum processing chamber 33 is pumped to a vacuum pressure, and a copper oxide removal process begins. Having described the preferred position of the inventive measurement tool 11a relative to a preferred vacuum processing chamber 33 (shown in FIG. 2A). The operation of the inventive measurement tool 11a is now described below with reference to the flow chart of FIG. 2B.

FIG. 2B is a flow chart which describes the operation of the inventive measurement tool 11a. As described further below, the operation described with reference to FIG. 2B (1) can be performed on each wafer processed; or (2) can be performed once (as a calibration step) on a wafer having a known copper oxide thickness so as to determine a copper oxide removal rate for a given chamber. Specifically, in operation, the inventive copper oxide measurement tool 11a (under the control of the controller 37) performs a plurality of copper oxide thickness measurements at various times during the copper oxide removal process. These measurements may be taken continuously or periodically, and may begin prior to the initiation of the copper oxide removal process, simultaneously therewith, or subsequently thereto (block 1). Each of the measured copper oxide thicknesses are provided to the controller 37.

As soon as the controller 37 receives the copper oxide thickness measurement of zero (upon the reflectivity measurement component 15's measurement of a reflectivity equal to that of pure copper) (block 2), the controller 37 either stops the copper oxide removal process immediately, or preferably continues the copper oxide removal process for a period of time sufficient to ensure that all copper oxide is removed from the surface of the substrate S. That is, the controller 37 may allow the copper oxide removal process to continue for a brief period of time while monitoring the copper oxide thickness measurements to ensure that a thickness of zero is consistently measured (block 3).

The controller 37 preferably records the time at which each copper oxide thickness is measured. Thereafter this information may be used to characterize the copper oxide removal process (e.g., to identify problems which may occur within the processing chamber 33) and/or to determine the copper oxide removal rate (block 4). After a copper oxide removal rate is determined for a given copper oxide removal process, the removal rate may be stored in the controller 37, and employed for determining an end point time (i.e., the time at which the final portion of copper oxide will be removed from any substrate which received processing/handling similar to that of the measured substrate S). Accordingly, after the copper oxide removal rate for the vacuum processing chamber 33 has been determined, the inventive copper oxide measurement tool 11a may be removed from the vacuum processing chamber 33 as the end points for substrates subsequently processed in the vacuum processing chamber 33 can be determined via the copper oxide removal rate. Thus, the inventive copper oxide measurement tool 11a itself is not needed for subsequent end point determinations.

Although the in situ measurement process described with reference to FIG. 2B is preferred, the inventive copper oxide removal tool 11a alternatively may be employed to perform a preliminary (i.e., prior to the commencement of the copper oxide removal process) copper oxide thickness measurement on a substrate S placed within the vacuum processing chamber 33. Thereafter the end point time for the substrate S may be calculated based on a previously determined copper oxide removal rate and the copper oxide removal process may be performed on the substrate S for the end point time. After the end point time is reached, the inventive copper oxide measurement tool 11a may optionally perform a subsequent copper oxide thickness measurement to insure that all of the copper oxide has in fact been removed.

As previously noted, the specific copper oxide thickness measurement tools and methods are described above with only general reference to the copper oxide removal process itself. The preferred copper oxide removal processes and the chambers configured to perform these processes will be described in detail with reference to FIGS. 3 and 4.

FIG. 3 is a side elevational view of a preferred semiconductor wafer processing system 31a ("processing system 31a") configured for copper oxide reduction processes. The processing system 31a comprises a processing chamber 41 operatively coupled to an atomic gas source 43 via an input pipe 45 and to a pump 47 via a foreline 49 and a throttle valve 51. A suitable processing system is the GIGAFILL$^{TM}$ processing system manufactured by Applied Materials, Inc. and described in commonly assigned U.S. patent application Serial No. 08/748,883, filed Nov. 13, 1996, which is hereby incorporated by reference herein in its entirety.

The processing chamber 41 comprises an inlet 53 operatively coupled to the input pipe 45 for receiving atomic gas from the atomic gas source 43, and a gas distribution plate 55 operatively coupled to the inlet 53 for distributing atomic gas along the surface of a semiconductor wafer disposed within the processing chamber 41. The processing chamber 41 further comprises a wafer support 57 located below the gas distribution plate 55 and having a heating mechanism (e.g., a ceramic heater 59) mounted thereto for supporting and heating a semiconductor wafer during processing within the processing chamber 41. The ceramic heater 59 has a maximum heating temperature of approximately 800°C and preferably comprises a material such as aluminum nitride. Other heating mechanisms comprising different materials and different temperature maxima may be employed.

The atomic gas source 43 comprises a molecular gas source 61 operatively coupled to a remote microwave plasma system 63. The molecular gas source 61 preferably comprises a source gas such as hydrogen or another gas species capable of reducing copper oxide (e.g., ammonia). The source gas may be diluted with an inert gas such as argon and/or helium (as described below).

The remote microwave plasma system 63 comprises a magnetron head 65 operatively coupled to a tuner 67, and a microwave applicator 69 (e.g., a sapphire applicator) operatively coupled to the tuner 67, to the input pipe 45 and to the molecular gas source 61. Specifically, the magnetron head 65, the tuner 67 and the microwave applicator 69 are operatively coupled via a waveguide system 71a-c that guides microwave energy generated by the magnetron head 65 to the microwave applicator 69.

The magnetron head 65 generates a pulsed or a continuous wave microwave output centered at approximately 2.5 GHZ with a power between about 0-3000 Watts. Any conventional magnetron head may be employed as the magnetron head 65.

Microwaves generated by the magnetron head 65 are output to the waveguide system 71a-c and travel through a first waveguide section 71a, a second waveguide section 71b and a third waveguide section 71c to the microwave applicator 69. The tuner 67 is operatively coupled to the third waveguide section 71c and comprises conventional microwave tuning elements (e.g., stub tuners, etc.) that allow the remote microwave plasma system 63 to match the characteristic impedance of the third waveguide section 71c (e.g., so as to reduce reflection of microwave power back to the magnetron head 65). Microwave power thereby is efficiently delivered to the microwave applicator 69.

In operation, to reduce a copper oxide layer formed on an underlying copper layer of a substrate S such as a silicon semiconductor wafer, the substrate S is loaded into the processing chamber 41 via a slit valve (not shown), is placed on the wafer support 57, the slit valve is closed, and the processing chamber 41 is evacuated via the pump 47. The base pressure of the processing chamber 41 is set by adjusting the throttle valve 51. A base pressure of about 0.4 Torr is presently preferred although other chamber pressures may be employed.

During evacuation of the processing chamber 41, power is applied to the ceramic heater 59 to raise the temperature of the substrate S to the copper oxide reduction temperature. Copper oxide reduction preferably is performed in the range of about 15-80°C. The ceramic heater 59, therefore, preferably is heated (or cooled) to about 15-100°C.

After the substrate S has reached the reduction temperature and after the processing chamber 41 has stabilized at the desired base pressure, the magnetron head 65 is turned on so as to apply microwave power to the microwave applicator 69, and molecular gas is flowed from the molecular gas source 61 to the microwave applicator 69. The microwave power level applied to the microwave applicator 69 is the power level required to generate a sufficient concentration of atomic hydrogen within the processing chamber 41 to affect copper oxide reduction. The appropriate power level depends on many factors (e.g., the concentration of atomic hydrogen (or another gas species capable of reducing copper oxide within the microwave applicator 69, the distance between the microwave applicator 69 and the substrate S, the material encountered by the atomic hydrogen as it travels from the microwave applicator 69 to the substrate S, etc.) as described further below. A power level of between 800-2,000 watts therefore is preferred.

Molecular hydrogen from the molecular gas source 61 travels into the microwave applicator 69 and is dissociated into atomic hydrogen by the microwave energy applied to the microwave applicator 69 by the magnetron head 65. Specifically, a window (now shown) in the microwave applicator 69 allows microwaves from the third waveguide section 71c to pass through the cuter portion of the microwave applicator 69 and to interact with molecular hydrogen therein. A plasma ignition system (e.g., an ultraviolet light) may be employed for the initial ionization of a hydrogen plasma, and the microwave energy then sustains the plasma. Only a small portion cf the hydrogen is ionized, and the plasma may comprise other ionized species if a diluting gas is present (such as argon ions if argon is employed as a diluting gas). The microwave applicator 69 thus creates a flow of atomic hydrogen that travels from the microwave applicator 69 to the input pipe 45 of the processing chamber 41.

Once the atomic hydrogen reaches the top surface of the heated substrate S, due to the high chemical potential of acomic hydrogen, the atomic hydrogen readily reacts with the copper oxide layer ($Cu_yO_x$) on the substrate S to form copper and water via the refaction:

$$Cu_yO_x + 2xH = yCu + xH_2O$$

The copper oxide layer thereby is "reduced" to copper which remains on the substrate S and the $H_2O$ which is volatile, leaves the surface of the substrate S and is exhausted from the processing chamber 41 via the pump 47.

As previously described, the present invention advantageously allows a copper oxide removal process, such as the copper oxide reduction process described with reference to FIG. 3 to be monitored and characterized. Another popular copper oxide removal process, reactive ion sputter etching, is described with reference to FIG. 4.

FIG. 4 is a cross-sectional view of a semiconductor wafer processing system 31b comprising an exemplary pre-clean chamber 73 that may be used to sputter etch copper oxide from an underlying copper layer (such as the Pre-Clean II Chamber available from Applied Materials, Inc., Santa Clara, California). Generally, the pre-clean chamber 73 has a substrate support member 75 disposed in a chamber enclosure 77 under a quartz dome 79. The substrate support member 75 typically includes a central pedestal plate 81 disposed within a recess 83 on an insulator plate 85, typically constructed of quartz, ceramic or the like. During processing, the substrate S is placed on the central pedestal plate 81 and contained thereon by locating pin 87. Preferably, an RF coil 88 is disposed outside of the quartz dome 79 and connected to an RF power source 89 to strike and maintain a plasma of the process gases within the chamber. Generally, a RF match network 91 is provided to match the RF power source 89 and the RF coil 88. Typically, the substrate support member 75 is connected to an RF bias source 93 that provides a bias to the substrate support member 75. The RF power source 89 preferably provides up to about 500W of 2 MHz RF power to the coil 88 and the RF bias source 93 preferably provides up to about 500W of 13.56 MHz RF bias to the substrate support member 75. During exemplary interconnect formation, a patterned or etched substrate S is preferably pre-cleaned using first an argon plasma and then a hydrogen plasma in the pre-clean chamber prior to the deposition of a barrier layer within the opening (e.g., a via, a trench, a wire, etc.) so as to remove any copper oxide formed therein. Preferably, the substrate S is transferred into the pre-clean chamber after a dielectric layer has been planarized and the openings of an interconnect feature have been formed. The pattern etching of the substrate S may be performed in another processing platform or system before the substrate is transferred to a processing platform or system having a pre-clean chamber. Once the substrate S is positioned for processing in the pre-clean chamber, a processing gas comprising predominantly argon, i.e., greater than about 50% argon by number of atoms, is introduced into the processing region at a pressure of preferably about 0.8 mTorr. A plasma of the argon gas is struck in the processing region to subject the substrate S to an argon sputter cleaning environment. The argon plasma is preferably generated by applying between about 50 W and about 500W of RF power from the RF power source 89 to the RF coil 88 and between about 50W and about 500W of RF bias from the RF bias source 93 to the substrate support member 75. The argon plasma is maintained for between about 10 seconds and about 300 seconds to provide sufficient cleaning time for the deposits on the substrate S that are not readily removed by a reactive hydrogen plasma. The argon plasma is most preferably generated by applying about 300W of RF power to the coil 88 and about a 300W RF bias to the substrate support member, and preferably is maintained for about 60 seconds.

Following the argon plasma, the chamber pressure is increased to about 80 mTorr, and a processing gas consisting essentially of hydrogen and helium, comprising between about 5% and about 100% hydrogen by number of atoms, is introduced into the processing region. Preferably, the processing gas comprises about 5% hydrogen and about 95% helium. A plasma of the hydrogen/helium gas is struck in the processing region to subject the substrate S to a reactive hydrogen plasma environment. The hydrogen plasma is generated by applying between about 50W and about 500W of power from the RF power source 89 to the RF coil 88 and between about 5W and about 300W of RF bias from the RF bias source 93 to the substrate support member 75. The hydrogen plasma is maintained for between about 10 seconds and about 300 seconds to reduce copper oxide to copper and to clean the substrate S. The hydrogen plasma is most preferably generated by applying about 450W of RF power to the coil and about a 10W RF bias to the substrate support member 75, and preferably is maintained for about 60 seconds. Once the pre-cleaning process is complete, the pre-clean chamber 73 is evacuated to exhaust the processing gas and the reacted byproducts from the pre-cleaning process.

As previously described, the present invention advantageously allows a copper oxide removal process, such as the sputter etching process described with reference to FIG. 4 to be monitored and characterized.

The foregoing description discloses only the preferred embodiments of the invention, modifications of the above disclosed apparatus and method which fall within the scope of the invention will be readily apparent to those of ordinary skill in the art. For instance, although the copper removal processes specifically described are vacuum processes, the present invention may also be employed to provide in situ measurements during non vacuum processes such as during chemical mechanical polishing (CMP). Conventional CMP tools press a substrate against a polishing pad, while moving (rotary or linearly) the substrate and or the polishing pad. An abrasive slurry or other liquid is supplied to the polishing pad to aid in the removal of material from the substrate. A window is provided in the polishing pad, through which the light source of the present invention may illuminate the substrate S in order to obtain the inventive reflectivity measurements.

The specific reflectivity and sheet resistance measurements described herein are merely preferred. Other measurements which measure a bulk property of copper through a copper oxide layer may be similarly employed. The specific measurement tools may vary from that described herein. Finally, the invention may be employed to measure the thickness of an oxide formed on any reflective metal, or the thickness of any layer which attenuates a characteristic of a layer which lies thereunder provided the attenuation of the characteristic varies with the thickness of the overlying layer. Analogously, resistance measurements can be used to monitor changes in the thickness of a poorly-conducting layer that overlays a metal layer during the process of transforming the poorly-conducting layer into the metal (similar to the reduction of copper oxide to copper).

Accordingly, while the present invention has been disclosed in connection with the preferred embodiments thereof, it should be understood that other embodiments may fall within the spirit and scope of the invention, as defined by the following claims.

**Claims**

1. A method of determining the thickness of a copper oxide for a structure comprising a copper layer having the copper oxide formed thereon, the method comprising:

   measuring a reflectivity of the structure to obtain a measured reflectivity value; and
   determining a thickness of the copper oxide based on the measured reflectivity value.

2. The method of claim 1 wherein determining a thickness of the copper oxide based on the measured reflectivity value comprises:

   providing a plurality of previously measured reflectivity values each obtained by measuring a reflectivity of a structure having a copper oxide of known thickness formed on a copper layer; and
   determining the thickness of the copper oxide based on the measured reflectivity value and the previously measured reflectivity values.

3. The method of claim 1 wherein determining a thickness of the copper oxide based on the measured reflectivity value comprises:

   providing a relationship between copper oxide thickness and a reflectivity value obtained by measuring a reflectivity of a structure having a copper oxide of known thickness formed on a copper layer; and
   determining the thickness of the copper oxide based on the measured reflectivity value and the relationship.

4. A method of monitoring a copper oxide removal process, comprising:

   providing a vacuum chamber adapted to perform a copper oxide removal process;
   coupling, to a window of the chamber, a tool adapted to measure a reflectivity of a structure having a copper oxide formed on a copper layer;
   performing the copper oxide removal process on a first substrate having a copper layer with a copper oxide formed thereon, while repeatedly measuring the reflectivity of the first substrate to obtain a plurality of reflectivity values; and
   determining a removal rate of the copper oxide based on the plurality of reflectivity values.

5. The method of claim 4 wherein determining a removal rate of the copper oxide based on the plurality of reflectivity values comprises:

   providing a plurality of previously measured reflectivity values, the previously measured reflectivity values measured on structures having copper oxides of known thicknesses on copper layers; and
   for each of the plurality of reflectivity values, determining a thickness of the copper oxide based on the measured reflectivity value and the previously measured reflectivity values.

**6.** The method of claim 4 wherein performing the copper oxide removal processes comprises reducing copper oxide to copper.

**7.** The method of claim 4 wherein performing the copper oxide removal process comprises etching copper oxide.

**8.** The method of claim 4 wherein determining a removal rate of the copper oxide based on the plurality of reflectivity values comprises:

providing a relationship between copper oxide thickness and reflectivity of a structure having a copper oxide formed on a copper layer; and determining a thickness of the copper oxide based on a measured reflectivity value and the relationship.

**9.** The method of claim 4, further comprising:

determining a length of time for the complete removal of the copper oxide from the first substrate;
placing a second substrate, having a copper layer with a copper oxide formed thereon, in a chamber adapted to perform the copper oxide removal process; and
performing the copper oxide removal process for a length of time at least as long as the length of time for the removal of copper oxide from the first substrate.

**10.** An apparatus comprising:

a vacuum processing chamber adapted to perform a copper oxide removal process;
a tool adapted to measure the reflectivity of a substrate having a copper layer with a copper oxide formed thereon positioned within the vacuum processing chamber; and
a controller adapted to determine the thickness of a copper oxide formed on the substrate based on the reflectivity measured by the tool.

**11.** The apparatus of claim 10 wherein the controller is adapted to determine the thickness of the copper oxide formed on the substrate by referencing a database of previously measured reflectivity values measured for structures having copper oxides of known thicknesses.

**12.** The apparatus of claim 10 wherein the controller is adapted to determine the thickness of the copper oxide formed on the substrate based on a previously determined relationship between copper oxide thickness and reflectivity as measured for a structure having a known copper oxide thickness.

**13.** An apparatus comprising:

a vacuum processing chamber adapted to perform a copper oxide removal process;
a controller adapted to control processing within the vacuum processing chamber; and
a program contained within the controller, the program adapted to cease performance of the copper oxide removal process based on a reflectivity value of a structure having a copper oxide formed on a copper layer; wherein the program is adapted to cease performance based on a reflectivity value which is entered prior to beginning the copper oxide removal process.

**14.** An apparatus comprising:

a tool adapted to measure the reflectivity of a structure having a copper oxide formed on a copper layer; and
a controller adapted to determine the thickness of a copper oxide based on the reflectivity measured by the tool.

**15.** The apparatus of claim 14 wherein the controller is adapted to determine the thickness of the copper oxide by referencing a database of previously measured reflectivity values measured on structures having copper oxides of known thicknesses on copper layers.

**16.** The apparatus of claim 14 wherein the controller is acapted to determine the thickness of the copper oxide formed on the structure based on a previously determined relationship between copper oxide thickness and reflectivity.

**17.** A method for determining the thickness of a copper oxide formed on an underlying copper layer, comprising:

measuring a resistance of the copper layer through the copper oxide to obtain a measured resistance value; and

determining a thickness of the copper oxide based on the measured resistance value.

18. The method of claim 17 wherein determining a thickness of the copper oxide based on the measured resistance value comprises:

providing a plurality of previously measured resistance values each obtained by measuring a resistance of a copper layer through a reference copper oxide of known thickness; and

determining the thickness of the copper oxide based on the measured resistance value and the previously measured resistance values.

19. The method of claim 17 wherein determining a thickness of the copper oxide based on the measured resistance value comprises:

providing a relationship between copper oxide thickness and resistance obtained by measuring a resistance of a copper layer through a reference copper oxide of known thickness; and

determining the thickness of the copper oxide based on the measured resistance value and the relationship.

20. An apparatus comprising:

a tool adapted to measure the resistance of a copper layer having a copper oxide formed thereon; and

a controller adapted to determine the thickness of a copper oxide based on the resistance measured by the tool.

21. The apparatus of claim 20 wherein the controller is adapted to determine the thickness of a copper oxide by referencing a database of previously measured resistance values measured through copper oxides of known thicknesses.

22. The apparatus of claim 20 wherein the controller is adapted to determine the thickness of a copper oxide based on a previously determined relationship between copper oxide thickness and resistance.

23. An apparatus comprising:

a tool adapted to measure a characteristic of a copper layer having a copper oxide formed thereon; and

a controller adapted to determine the thickness of a copper oxide based on the characteristic measured by the tool;

wherein the tool is adapted to measure the characteristic through a copper oxide.

24. The apparatus of claim 23 wherein the controller is adapted to determine the thickness of a copper oxide by referencing a database of previously measured characteristic values measured through copper oxides of known thicknesses.

25. The apparatus of claim 23 wherein the controller is adapted to determine the thickness of a copper oxide formed on the substrate based on a previously determined relationship between copper oxide thickness and the characteristic, as measured through a copper oxide.

26. A method for determining the thickness of a copper oxide formed on an underlying copper layer, comprising:

measuring a characteristic of the underlying copper layer through the copper oxide to obtain a measured characteristic value; and

determining a thickness of the copper oxide based on the measured characteristic value.

27. The method of claim 26 wherein determining a thickness of the copper oxide based on the measured characteristic value comprises:

providing a plurality of previously measured characteristic values each obtained by measuring a characteristic of a copper layer through a reference copper oxide of known thickness; and

determining the thickness of the copper oxide based on the measured characteristic value and the previously measured characteristic values.

28. The method of claim 26 wherein determining a thickness of the copper oxide based on the measured characteristic value comprises:

providing a relationship between copper oxide thickness and a characteristic value obtained by measuring a characteristic of a copper layer through a reference copper oxide of known thickness; and
determining the thickness of the copper oxide based on the measured characteristic value and the relationship.

29. The method of claim 1 further comprising:
chemically mechanically polishing the copper oxide while measuring reflectivity.

30. A method of determining the thickness of an oxide for a structure comprising an oxidizable layer having the oxide formed thereon, the method comprising:

measuring a property of the structure to obtain a measured value; and
determining a thickness of the oxide based on the measured value of the property.

31. The method of claim 1 wherein determining a thickness of the oxide based on the measured value comprises:

providing a plurality of previously measured values each obtained by measuring the property of a structure having an oxide of known thickness formed thereon; and
determining the thickness of the oxide based on the measured value of the property and the previously measured values.

32. The method of claim 1 wherein determining a thickness of the oxide based on the measured value comprises:

providing a relationship between oxide thickness and a value obtained by measuring a property of a structure having an oxide of known thickness formed on an oxidizable layer; and
determining the thickness of the oxide based on the measured value and the relationship.

FIG. 1A

FIG. 1B

FIG. 2A

```
┌─────────────────────┐
│ Perform plurality of│
│ Copper oxide        │ ──── 1
│ measurements        │
└─────────────────────┘
          │
          ▼
┌─────────────────────┐
│ measure zero        │ ──── 2
│ copper oxide        │
└─────────────────────┘
          │
          ▼
┌─────────────────────┐
│ Zero Copper Oxide   │
│ measured for        │ ──── 3
│ a predetermined     │
│ period of time      │
└─────────────────────┘
          │
          ▼
┌─────────────────────┐
│ Determine           │
│ Copper oxide        │ ──── 4
│ removal             │
│ rate                │
└─────────────────────┘
```

FIG. 2B

FIG. 3

Fig. 4

EP 1 143 222 A1

FIG. 5A

FIG. 5B